# EUROPEAN PATENT APPLICATION

(11) **EP 2 031 664 A2**
(43) Date of publication of application: **04.03.2009**
(21) Application number: 08425100.8
(22) Date of filing: 18.02.2008
(51) Int. Cl.: H01L 31/058

(54) **Integrated solar panel for the combined production of electric energy and hot water**

(30) Priority: 22.02.2007 IT BO20070094
(71) Applicant: Tespi Srl, 20121 Milano (IT)
(72) Inventor: Rosa Clot, Paolo, 56127 Pisa (IT); Rosa Clot, Marco, 56127 Pisa (IT); Carrara, Sandro, 17024 Finale Ligure (SV) (IT)
(74) Representative: Lanzoni, Luciano

(57) **Abstract**

The invention is a solar panel including: a system for the production of electric energy (4), and a system for the management of a water layer fit to the production of hot water (2) and electric energy, with an higher efficiency of electric energy production in comparison to other state of the art systems, and providing efficient thermal heating of water. The element of novelty of the industrial invention hereby lays in the particular system for the management of the water layer: on the one hand, the invention generates a very efficient system for electric energy production, and on the other hand, it allows the thermal heating of the water.

## Description

### Technical division (WIPO classification):

H01L - Semiconductor devices; solid-state electrical devices 31/058 including the use of thermal energy, hybrid systems, supplemental sources of thermal energy

### Synopsis

The invention is a solar panel including: (1) a system for the production of electric energy, and (2) a system for the management of a water layer fit to the production of hot water and electric energy, with an higher efficiency of electric energy production in comparison to other state of the art systems, and providing efficient thermal heating of water. The element of novelty of the industrial invention hereby lays in the particular system for the management of the water layer: on the one hand, the invention generates a very efficient system for electric energy production, and on the other hand, it allows the thermal heating of the water.

### State of the art:

The industrial invention hereby, concerns a solar panel able to produce thermal energy and electric energy in a combined way (Thermal Electric Solar Panels Integration, TESPI).

In general, a solar panel for thermal energy production is simply a panel in which water heats up by mere circulation. These panels usually contain thin copper tubes for water flowing. The tubes are incorporated in a structure having, on the one side, fiberglass, and, on the opposite one, a smooth layer of glass to let sunlight reach the copper tubes. These structures are packed in panels called "solar panels" by means of aluminum cases and rubber washers. However, the solar panels built with this technique have several disadvantages. They are systems where a fluid (usually oil, sometimes water) flows in copper tubes transferring heat to a water mass, stored in a well-insulated container. This makes the system efficient, but, at the same time, expensive: market costs are rather high, up to €500 /m².

The available systems for electric energy production from solar radiation are, mainly, solar photovoltaic cells. Photovoltaic cells are made with semiconductor-based systems and, thanks to the photoelectric effect, are able to produce electric energy from the simple reception of solar radiation on the semiconductor's surface. Every photon hitting the semiconductor's surface produces a current quantum that can be used to accumulate electric energy in an accumulator. Although, on the one hand, this is a very simple method for producing virtually unlimited (on a human time scale) electric energy from a renewable source, on the other hand it has serious disadvantages. Probably the main one consists in the fact that a photovoltaic panel requires more energy to be built than it is able to produce during its life span. In other words, with the best technology today available in the state of the art, the balance between the energy required to build the cell, and the energy the cell is able to produce, is a negative one. This is a consequence, of the panel's low efficiency: a photovoltaic panel, in fact, can absorb only a part of the spectrum (typically, only its visible part, that is 40% of the solar spectrum). Furthermore, the performance of almost every system drops along with the increase in temperature: in particular, silicon passes from an efficiency around 12-15% at 25° C., to 9-12% at 70°C). Therefore, it would be desirable that new technologies would offer a better efficiency in solar energy conversion for photovoltaic panels.

To augment the efficiency of photovoltaic cells, the state of the art suggests to use air or water to lower their temperature, and presents several inventions combining the production of thermal energy with the production of electric energy. There are as many as 139 American patents on Thermal-Photovoltaic cells, and 16 of these are related to water. However, many of the latter are related to the use of solar cells in solar pond based plants (1), or to extract water from air humidity (3). Some patents include the use of a water or air layer surrounding the photovoltaic system to merely lower its temperature (3). There is also a recent 2002 patent regarding a flexible system to realize roofs by means of a rolling system including, in addition to a photovoltaic system for the production of electric energy, the possibility of generating heat to supply an exchanger by heating up air or water. (4). This patent defines a system made with a coating with thickness in the range 75 µm to 1 mm, and air running through it and fluxing on the photovoltaic system. By means of an exchanger, the air is used to heat up water. The patent indicates the possibility of heating up water directly, but this is a very generic statement involving a water layer of no more than 1 mm. Other patents refer to similar systems. For example, these patents propose slightly different architectures for the management of the thin layer of cooling air 5), or, alternatively, systems realized with materials with high thermal capacity, located where air flows on the rear of the photoelectric system, thus cooling down the photovoltaic component (6). Also, there are patents involving water-based systems, but they all suggest complex architectures involving more than one fluid, and special fluids with suspended magnetic particles to ensure the circulation of the liquids and the thermal exchange (7), or using the hot water produced from the absorption of the solar energy, as a source of energy to produce electric energy(8). Finally, there is a patents concerning the cooling of photovoltaic system using a light concentrators (9). However, none of the inventions in the state of the has such architectures to optimize the thermal energy output of a photovoltaic panel.

The present invention, on the contrary, deals with a very particular architecture for a photovoltaic/thermal integrated system aiming to optimize the conversion factor of solar energy in electric and thermal energy (and, therefore, to cut production costs). In particular, the invention hereby described, also exploits the infrared-a radiation lost in normal photovoltaic cells-, cuts the cost of present solar panels, and improves the efficiency of the photovoltaic component by lowering its temperature. In addition, the invention hereby is peculiar and characteristic because locates the thermal panel entirely or partially in front of the photovoltaic one, exploiting the superior characteristics of water as an infrared absorber, and suggests an optimized architecture for the exploitation of the aforementioned infrared component.

### Invention Description:

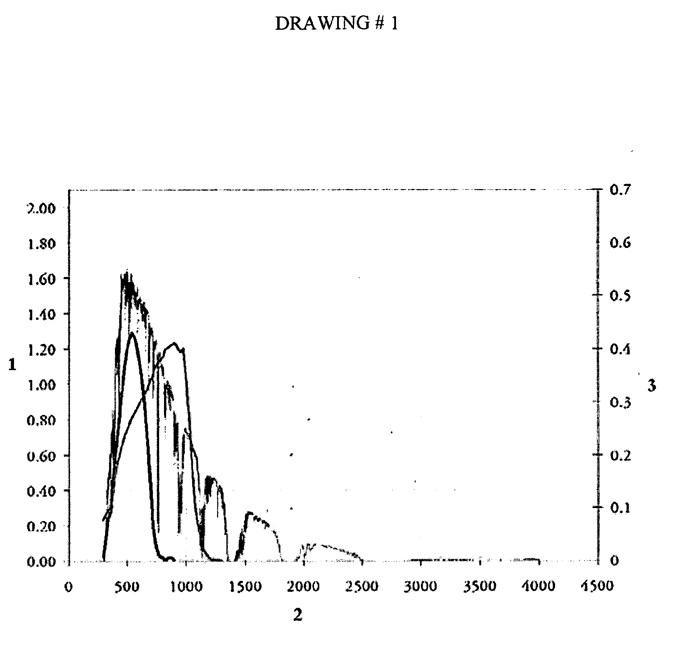

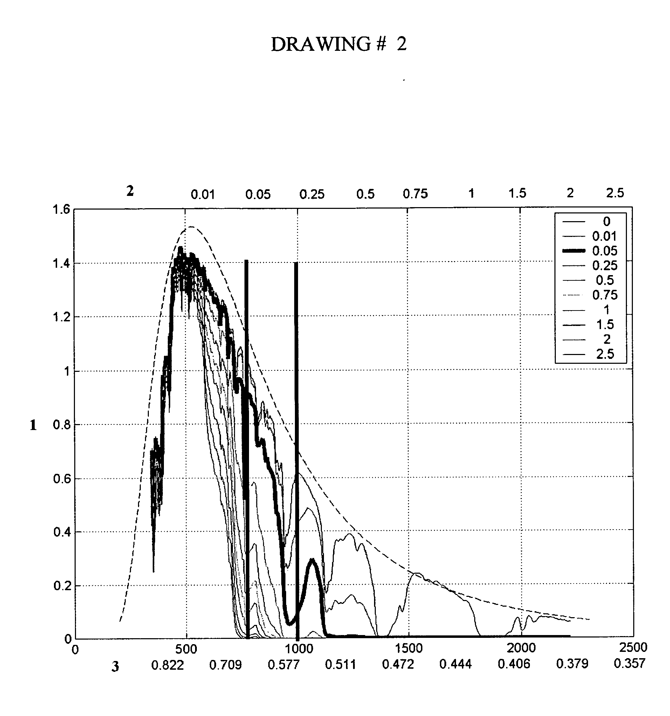

Figure 1 depicts the solar spectrum, and the absorbing curve of monocrystalline silicon and of amorphous silicon: (1) = irradiate power, (2) = wavelength in nm, (3) = spectral response. Lower efficiency of amorphous silicon is mainly caused by the impossibility of converting in current photons with a wavelength higher than 750 µm. Fig. 2, instead, shows only the solar spectrum in function of the thickness of the water layer the radiation must pass through (1) = black-body radiation, (2) = depth in meters; (3) = absorption coefficient. Five centimeters of water are sufficient to completely strip the spectrum of the infrared, and to reduce the radiation by 30%. The two black bars represent the threshold for monocrystalline silicon and of amorphous silicon photovoltaic.

The two figures highlight a fact that can be effectively exploited:

Five cm. of water can absorb 30% of solar radiation with negligible diminishing of the conversion capacity on the amorphous silicon, and very slight reduction of the efficiency on the monocrystalline silicon (from 15% to 13%).

This last reduction is in part compensated by the better efficiency obtained by keeping silicon at a relatively low temperature.

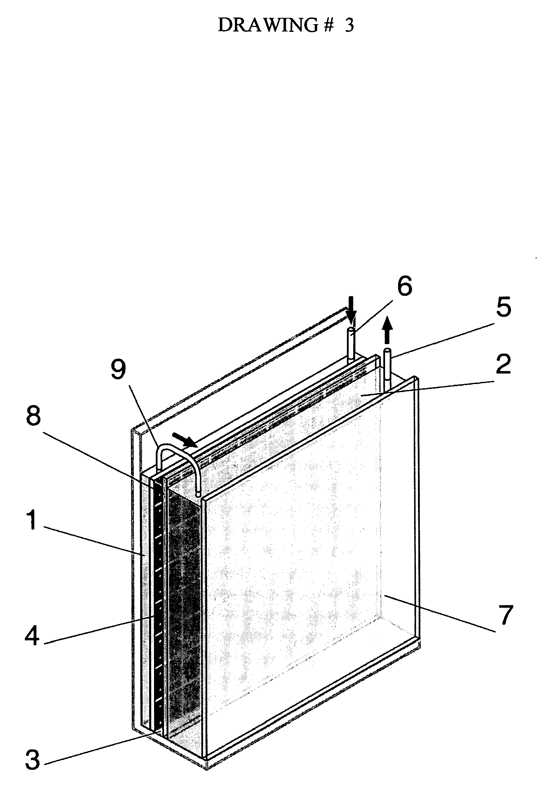

Therefore, the invention hereby aims at the realization of hybrid systems, coupling heat and current production by means of a photovoltaic system protected with a water layer. The invention hereby, proposes a configuration fit to this aim: a solar panel is built *ad hoc* with flowing water and integrated photovoltaic. Figure 3 shows the outline of the invention: a system supplied with a water layer about 2 cm wide **(1)** removes part of the heat from the panel support by bringing water to a temperature around 40 °C. The water then flows in the front by through of a 5 cm wide camera **(2)** where it absorbs an additional energy growing up to 30% its temperature, and rising to 70 °C. This last part is separated from the cell **(4)** by a thin air layer **(3).** The system is equipped with a water input **(6)** and output **(5)** to let the water flow, in order both to cool don the cell, and to produce thermal energy. The proposed panel can have a thermal efficiency of 80% the efficiency of a traditional thermal panel, and an electric efficiency similar to the one of a conventional photovoltaic panel.

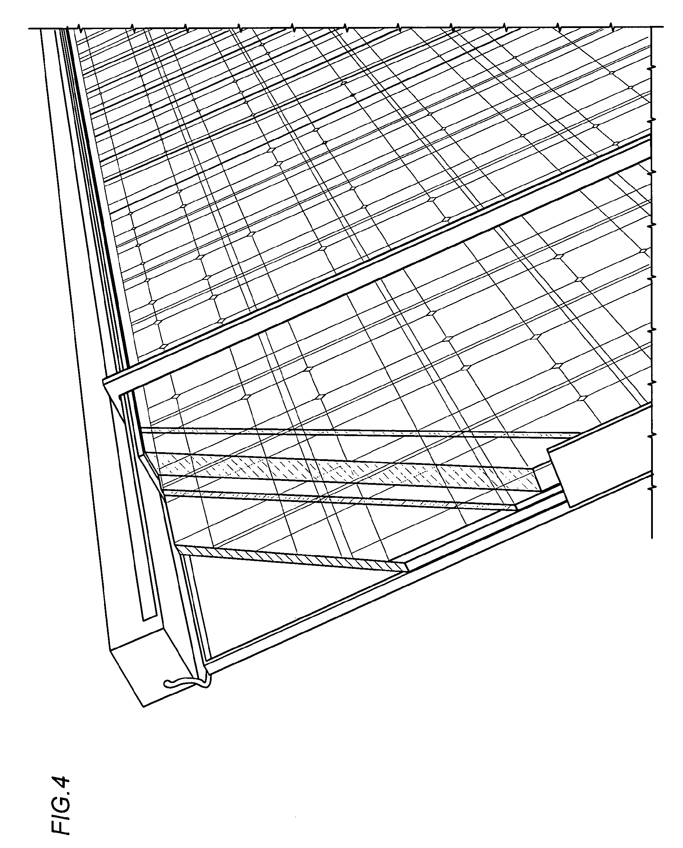

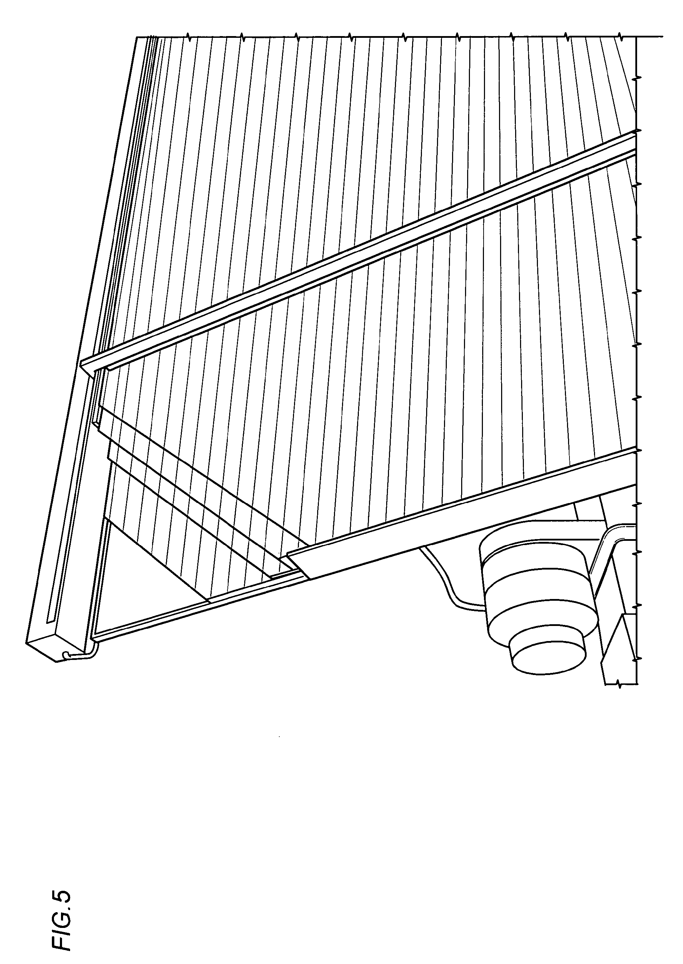

Figures 3 and 4 show some possible realizations of thermal-photovoltaic panels related to the invention hereby. The figures have a merely exemplificative intent, and the possible realizations are by no means limited to them.

### Expected advantages of the industrial invention:

a) Low-cost and high-efficiency thermal collector coupled with a photovoltaic panel without reducing (and in some cases increasing) the efficiency of the latter.
b) Exploitation of the infrared before it reaches silicon (where it will be lost) to produce thermal energy.
c) Low cost of thermal production compared to existing solar panels

### Bibliographical references:

(1) American patent n. 6,828,499, Apparatus and method for harvesting atmospheric moisture
(2) American patent n. 6,828,499, Apparatus and method for harvesting atmospheric moisture
(3) American patent n. 6,489,553, TPV cylindrical generator for home cogeneration
(4) American patent n. 6,472,593, Hybrid roof covering element
(5) American patent n. 5,589,006, Solar battery module and passive solar system using same
(6) European patent n. EP 0 820 105, Solar cell module and hybrid roof panel using the same
(7) American patent n. 5,772,792, Solar generator
(8) American patent n. 4,235,221, Solar energy system and apparatus
(9) American patent n. 6,407,328, Photovoltaic Device

## Claims

1. A system for the production of both electric energy and thermal energy, composed of a layer of water **(1);** a second layer of water **(2);** a thin layer of air **(3);** a photovoltaic cell **(4);** where the two water layers have the precise scope of cooling down the photovoltaic cell, and to produce thermal energy by means of direct heating.

2. A system as per claim 1 where the water layer **(1)** is 2 cm thick and has the purpose of removing from the supporting side part of the heat, bringing the water to about 40 °C.

3. A system as per claim 2 where the second water layer **(2)** is 5 cm thick and has the purpose of absorbing more thermal energy bringing the water to about 70 °C.

4. A system as per claim 3 where the efficiency of thermal energy production reaches 80% of a conventional thermal panel.

5. A system as per claim 4 realized in a photovoltaic-thermal panel equipped with a water layer **(1)** around 2 cm thick, that removes part of the heat from the panel support, by bringing the water to a temperature around 40 °C.; equipped with a second water layer **(2)** 5 cm thick where an additional 30% of the temperature reaching 70 °C; equipped with a common photovoltaic cell **(4)** separated from the second water layer with a thin air layer. **(3)**

6. A system as per claim 5, where the proposed panel can have a thermal efficiency around 80% of a thermal panel and an electric efficiency only slightly different from the one of a conventional photovoltaic panel.

7. A system for the production of electric energy and thermal energy according to claims 1 to 6 and according to what has been described and explained in reference.
